# NEW EUROPEAN PATENT SPECIFICATION

(11) **EP 2 097 908 B2**
(45) Date of publication and mention of the opposition decision: **23.08.2017**
(45) Mention of the grant of the patent: 01.02.2012
(21) Application number: 07873584.2
(22) Date of filing: 02.11.2007
(51) Int. Cl.: H01B 1/22, H01B 1/12, H01Q 1/24, H05K 1/09, C09D 133/02, C08K 3/08

(54) **WATERBORNE CONDUCTIVE COMPOSITIONS**
WÄSSRIGE LEITFÄHIGE ZUSAMMENSETZUNGEN
COMPOSITIONS CONDUCTRICES AQUEUSES

(30) Priority: 22.12.2006 US 876764 P
(43) Date of publication of application: 09.09.2009
(73) Proprietor: Henkel AG & Co. KGaA, 40589 Düsseldorf (DE)
(72) Inventor: FOREMAN, Paul, B., Somerville, NJ 08876 (US); MORGANELLI, Paul, Upton, MA 01568 (US); YUYAMA, Hajime, Princeton, NJ 08540 (US); VAN VEEN, Adrianus, Peter, NL-9679 GG Scheemda (NL)
(86) International application number: PCT/US2007/083445
(87) International publication number: WO 2008/127397

(56) References cited:
- EP-A2- 0 230 303
- US-A- 5 286 415
- US-A- 5 492 653
- US-A- 5 658 499
- US-A- 5 756 008
- US-A- 5 855 820
- US-A1- 2002 062 990
- US-A1- 2005 239 947

## Description

### FIELD OF THE INVENTION

This invention relates to waterborne conductive compositions that can be applied onto substrates as printable inks for use as electrical circuits in, for example, intelligent and active packaging, sensors, and RFID antennas.

### BACKGROUND OF THE INVENTION

In the past, waterborne conductive polymer thick film formulations, used as conductive inks, have typically exhibited less than optimum rheology, adhesion, and flexibility when printed and cured on certain substrates, and in particular on flexible substrates. Aqueous polymeric compositions used as printable conductive inks are disclosed, for example, in US Patent Nos. 5,286,415 corresponding to the preamble of claim 1 of the present invention, and 5,389,403 (Advanced Products, Inc.) describing an aqueous conductive polymer composition comprising a thermoplastic polymer, such as polyacrylic acid, a water insoluble polymer dispersion in water, a glycol compound, a conductive filler, and water; US Patent No. 6,866,799 (Anuvu, Inc.) describing an aqueous polymeric composition comprising a water-soluble acrylic polymer copolymerized with another polymer such as styrene, a conductive filler, a water-soluble wetting agent, water, and, to augment the composition, a water-soluble elastomer; US Patent No. 5,492,653 (Heraeus, Inc.) describing a coating composition comprising 30 to 80% by weight of a coated silver flake, a substantially completely water soluble polymer binder, diethyleneglycol monobutyl ether, and water; and US Patent No. 5,658,499 (Heraeus, Inc.) describing a waterborne coating composition consisting essentially of 30 to 80% by weight of coated silver flake, a substantially completely water soluble binder, other additives, and water. However, these compositions do not meet all the performance requirements needed in today's conductive ink applications.

A further water based conductive composition is described in US 5,855,820.

Metal powders, such as irregularly shaped or spherical silver powders, have been prepared in the past but such powders, when formulated, printed and fired, result in relatively low electrical conductive efficiency. Moreover, conventional flake silver powders when formulated at above 85% solids loading often show poor screenprinting characteristics because of excessive viscosity, which leads to porosity and defects in the printed patterns after drying. Practically useful viscosity improvements are achieved when a substantial portion of the flake silver powder is replaced by non-flake powder. Such a replacement, however, seriously impairs conductive efficiency.

Thus, there remains a need for waterborne conductive coatings that contain high levels of conductive materials (such as metal flakes) and that maintain excellent electrical conductive efficiency while possessing viscosities that provide good printing characteristics.

### SUMMARY OF THE INVENTION

This invention is directed to waterborne conductive compositions comprising metal flakes or particles, an alkali-soluble acrylic or methacylic acid copolymer in an effective solvating amount of water and alkali to dissolve the acrylic acid copolymer, a water-insoluble polymer dispersed in water; and optionally, a film coalescing (or wetting) agent, a plasticizer, or both.

### BRIEF DESCRIPTION OF THE DRAWINGS

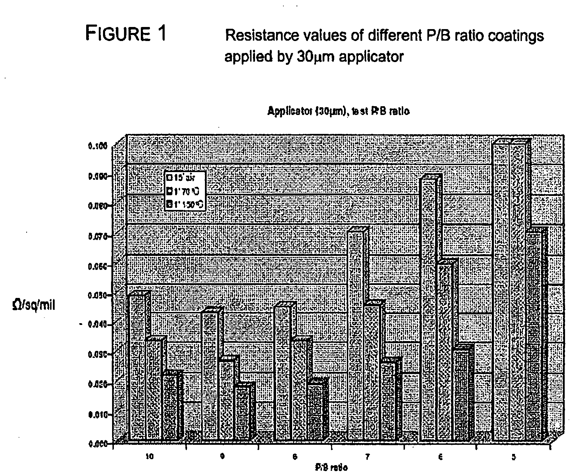

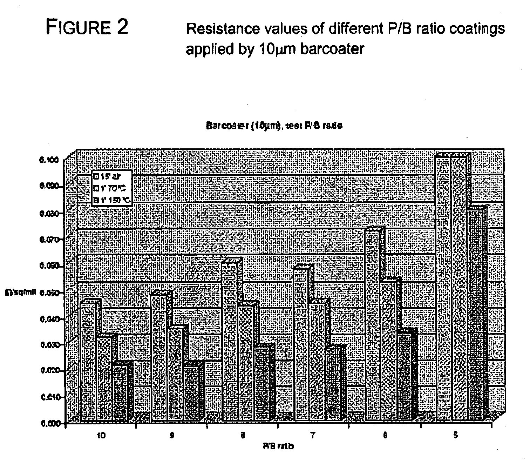

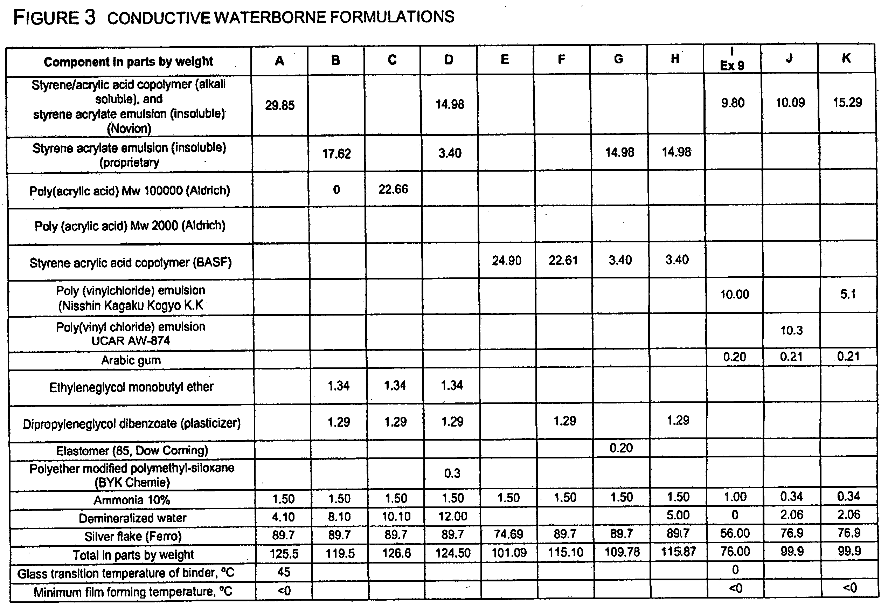

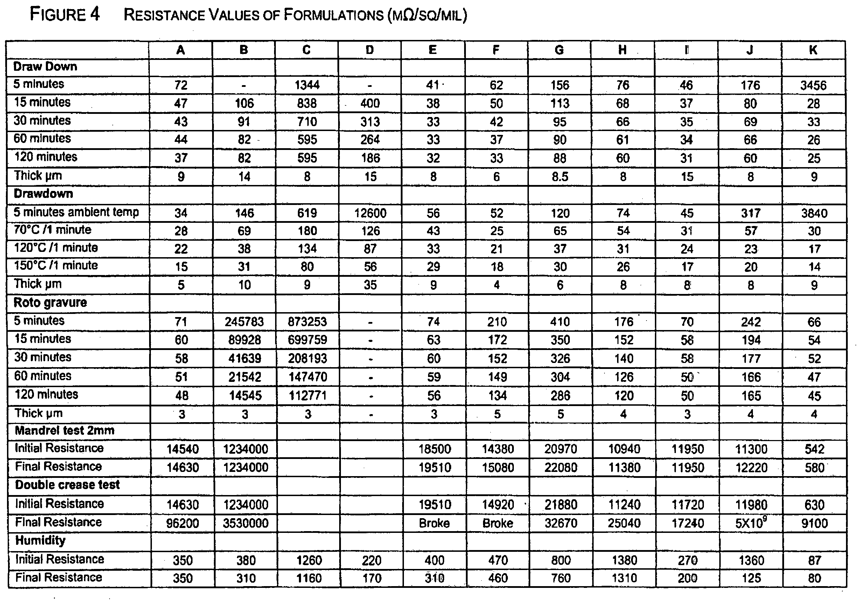

Figure 1 is a graph of the resistance values of different pigment to binder (P/B) ratio coatings applied by 30µm applicator. Figure 2 is a graph of resistance values of different P/B ratio coatings applied by 10µm bar coater. Figure 3 is a chart of conductive waterborne formulations. Figure 4 is a chart of the resistance values for those formulations.

### DETAILED DESCRIPTION OF THE INVENTION

The metal flakes or particles suitable for use in this invention are any that provide electrical conductivity. By "flake" is meant a material whose predominant shape is flake as determined by scanning electron microscopy. Suitable metallic flakes and particles include any of the noble metals and in one embodiment are silver flakes or particles. In another embodiment the conductive material is a bimodal silver flake having a mean mass diameter (D50) of 3µm and a 90% diameter (D90) of 8.8µm. The "mean mass diameter (D50) is the diameter at which 50% of the flakes, by mass, have a smaller diameter than the value in question, while 50% by mass have a larger diameter. The value D90 is the diameter at which 90% of the flakes, by mass, have a smaller diameter than the value in question. Particles of metal may be added to complement the bimodal flakes.

In one embodiment the metal is silver (Ag), or silver-coated copper, coated with oleic acid. In another embodiment, the oleic acid is coated in a mono-molecular layer in a range of about from 0.05% to 5% by weight on the surfaces of at least two-thirds of the flakes.

The viscosity of the waterborne conductive composition of this invention varies directly with the load of the metal flakes. The load of the metal flakes can be expressed as the ratio of metal pigment (i.e. flakes and particles) to binder. The pigment to binder ratio gives the amount of metal flake relative to the amount of polymer in the acid-stabilized aqueous polymer emulsion. For example, a waterborne conductive composition containing 2000g of silver and 500g of aqueous polymer emulsion (that contains 40% solids) has a pigment to binder ratio of 10.

To determine the influence of silver filler to binder ratio a range of waterborne conductive compositions was produced with silver filler to binder ratios ranging from 5 to 10. The waterborne conductive compositions were applied on polyester with a 30µm applicator and a 10µm bar-coater and electrical resistance values determined. These resistance values are presented in Figures 1 and 2. For both application methods it was found that the best (i.e. lowest) electrical resistance was obtained with a silver filler to binder ratio (that is, the ratio between the metal filler and the remaining solids content of the composition) between about 8 to about 10, preferably about 9.

Suitable metal flakes and particles are available commercially. Preferred metal flakes and particles are those that exhibit high dispersibility during formulation allowing high solids levels in the waterborne conductive compositions.

Small amounts of other metal powders and/or flakes may be incorporated in the waterborne conductive compositions of the invention to provide various modifications of the printable inks. Nickel powder, for example, may be added to modify release properties, physical strength, appearance and other aspects.

The alkali-soluble (meth)acrylic acid copolymers in the present invention are copolymers of acrylic acid or methacrylic acid, preferably acrylic acid, with one or more hydrophobic ethylenically unsaturated comonomers such as styrene, alkyl(meth)acrylates and the like. Preferred is styrene. The carboxylic acid content required for alkali solubility will depend upon the choice of acid and upon the hydrophobicity of the comonomers. In the case of styrene as comonomer about 30 weight% acrylic acid is required or about 60 weight% methacrylic acid. The molecular weight of the alkali soluble component will influence the viscosity of the binder, higher molecular weight obviously giving rise to higher viscosity all else being equal. A preferred weight averaged molecular weight (Mw) range is about 1,000 to 10,000 daltons, more preferably 1,500 to 6,000 as determined by gel permeation chromatography (GPC) using polystyrene standards. However, it will be apparent to one skilled in the art that higher molecular weight alkali soluble copolymers may be useful depending upon the viscosity constraints of the printing process.

When used to stabilize an otherwise surfactant free insoluble emulsion polymer a typical level of alkali soluble copolymer is about 10 to 20 weight% calculated on the total dry polymer (soluble plus insoluble components). A lesser amount may be used when additional surfactant stabilization is present. A greater amount may be used if added following polymerization of the insoluble polymer component. The amount of alkali soluble copolymer present in the conductive ink will be in the range 0.3 to 5 weight%, preferably 0.5 to 2 weight%, calculated on a dry basis.

The (meth)acrylic acid copolymer is solubilized in water by the presence of a suitable amount of base to neutralize the acid and stabilize it in solution. Any base that accomplishes the neutralization is acceptable, but a preferred base is ammonium hydroxide due to its volatility. One skilled in the art would be familiar with similar basic (alkali) materials suitable for neutralizing the acrylic acid copolymer and having the property of volatility.

Examples of suitable water-insoluble polymer dispersions include dispersions of styrenic, polyurethane, acrylic, polyester and vinyl resin polymers in water. Useful are copolymers of styrene with one or more ethylenically unsaturated monomers. Ethylenically unsaturated monomers include, without limitation, esters of acrylic and methacrylic acids, acrylamide, methacrylamide, N-substituted amides such as t-butyl acrylamide and N-vinylpyrrolidone, nitriles such as acrylonitrile, carboxylic acids such as acrylic acid, methacrylic acid, itaconic acid and the like. Particularly useful are copolymers of styrene with C₁-C₁₈, preferably C₁-C₈, alkyl acrylates or methacrylates. Such styrene-(meth)acrylic copolymers may further comprise a carboxylic acid monomer such as acrylic or methacrylic acid. An example of a preferred water-insoluble polymer dispersion is a copolymer of styrene with 2-ethylhexyl acrylate. Vinyl resins include copolymers of a vinyl monomer such as vinyl acetate, vinyl propionate, vinyl versatate, vinyl chloride and the like with one or more monomers including ethylene, alkyl acrylates or methacrylates, carboxylic acids or other ethylenically unsaturated monomer.

The water insoluble polymer dispersion may be stabilized with the alkali soluble copolymer, with conventional anionic and/or nonionic surfactants, or a combination of both.

The ratio of alkali soluble to insoluble polymer components will be dictated by the total content of carboxylic acid present. A preferred level is about 1 to 10 weight %, more preferably 3 to 6 weight %, calculated on total dry polymer. The amount of water-insoluble polymer dispersion present in the conductive ink will be in the range 1 to 15 weight %, preferably 2 to 10 %, more preferably 4 to 8 %, calculated on a dry basis.

Examples of suitable plasticizers include esters of polycarboxylic acids such as phthalic acid, isophthalic acid, terephthalic acid, adipic acid, azelaic acid, sebacic acid, and mellitic acid. Phosphoric acid esters, such as trioctyl phosphate, tricresyl phosphate, tritolyl phosphate and trixylyl phosphate, and polyester plasticizers such as polypropylene laurate, soya bean oil derived plasticizers such as epoxidized soya bean oil and chlorinated paraffins may also be used. Particularly suitable plasticizers include the Z4 alkyl esters of dicarboxylic acids, examples of which include dibutyl phthalate, dihexyl phthalate, dioctyl phthalate, di-iso-octyl phthalate, dinonyl phthalate, a mixture of C₇₋₉ dialkyl phthalates, ditridecyl phthalate, butyl benzyl phthalate, dibutyl adipate, dihexyl adipate, dioctyl adipate, di-iso-octyl adipate, dibutyl sebacate and dioctyl sebacate. High boiling point glycol componds such as dipropyleneglycol dibenzoate are also suitable.

Suitable film coalescing or wetting agents include lower boiling point glycol compounds, such as, ethylene glycol monobutyl ether. This compound has the advantage of greater volatility over higher molecular weight compounds. Examples of suitable glycol coalescing agents include 1,3 butylene glycol; propylene glycol and ethylene glycol. These agents may be used singularly or in combination with each other.

The level of coalescing agents and plasticizers will be determined by the glass transition temp of the polymer components. A person of ordinary skill will select an amount, if required, that is sufficient to create a flexible, continuous film upon drying but not so much as to leave a tacky coating upon drying.

The combination of alkali-soluble acrylic acid copolymer in water, water-insoluble polymer dispersion, glycol compound, if any, and plasticizer, if any, without any metallic filler, will be referred to hereinafter as the binder for the metal filler.

One method of dispersing the metal flakes and/or particles is to use a high speed dispersing mixer of the type available from MorehouseCowles or Charles Ross and Son Company. Generally, the quantity of metal flakes and/or particles added is two to four (or more) times the weight of the binder. Mixing is initially slow and then when the flakes of conductive material have been fully incorporated into the binder, the dispersion is mixed at a higher speed for a short time with care being taken to avoid introducing air into the mixture. In one embodiment, the temp of the dispersion is not allowed to exceed 30-35°C during mixing. If required, the final product may be filtered using an appropriate sized silk mesh filler. The mixing process produces a visually homogeneous mixture in liquid.

The alkali soluble polymer assists in the initial wetting and incorporation of the conductive filler to give a uniform dispersion of the particles or flakes. It further serves to prevent hard packing of the filler during storage and enables any settled particles to be easily redispersed by stirring or shaking.

In further embodiments, the invention comprises disposing the waterborne conductive compositions as conductive coating inks on a substrate as one or more narrow lines, thereby forming at least one conductive trace on the substrate, or disposing as a film covering at least a portion of a surface of said substrate.

The viscosity and printing properties of printable electrical conductors should be adjusted prior to printing on the press and held constant during printing through the appropriate use of additives. This can be achieved by adding ammonia water and minimal amounts of specially selected antifoaming agents if needed. Depending on the printing method and duration of the print run, the addition of dilute ammonia and 0.01 - 0.2% by volume antifoaming agent may be necessary. Such addition should be done immediately prior to printing and the combination mixed well. The amounts and frequency of later additions are dependent on the ink properties, structure of the press, exposed surfaces of the conductive composition, ambient temperature, humidity, printing speed and other factors. Closed ink recirculation systems, coupled to a slow ink circulating pump, are best for keeping the physical properties of the printed electronic conductors constant.

Generally speaking, the present invention provides waterborne conductive compositions for use as printable electrical conductors, where such conductive compositions can be utilized with existing, commercially available printing presses for the printing of electrically conductive traces on a variety of substrates. In the preferred embodiments conductivity is achieved through the use of fine flakes of metallic silver or silver-coated copper suitably mixed in the binder described herein, with the resulting composition being available for use in a printing press.

The conductivity of printable electrical conductors in use depends on a number of factors including the position, arrangement, and physical connections among the metal flakes and/or particles within the composition that is deposited onto the substrate. Conductivity and stability are influenced by the film drying process, the application or operation of heating/curing media, and external treatment processes such as acid wash, applied pressure, and high energy light treatments.

It is desirable to achieve proper orientation and close positioning among the metal particles without the formation of a thick polymer particle surface-wetting layer. This is accomplished by selection of raw materials and correct preparation of the vehicle. It is also beneficial to prepare the metal surface through the use of techniques such as particle surface treatment.

The formation of a binder layer on top of metal particle surfaces is desirable to achieve proper particle deposition during the printing process. The binder layer also facilitates adherence of the particles to the substrate material, and enhances inter-particle consolidation after the drying process.

Printable electrical conductors tend to dry quickly after printing because of the low percentage of liquid in the metal dispersion. The pH of the waterborne conductive compositions is adjusted typically to a pH in the range of 7.5 to 10.5; in another embodiment, to a pH in the range of 8 to 10; and in a further embodiment, to a pH in the range of 8.5 to 9.5. In one embodiment within these ranges, the pH is initially at 7.5 to 8.5 and as within all ranges drops when the ammonia water evaporates. During this process the polymer system goes from a water-soluble state to a water-insoluble state. The drying process can be facilitated by forced convection with ambient or slightly elevated temp air. This process plays a role in determining the conductive properties of the final product. It is postulated that because the inventive compositions are quick drying, when printed to form conductive traces, the printed trace shrinks rapidly and creates compression between the metallic flakes or particles. This compression increases connections and, consequently, greater conductivity over other compositions.

### EXAMPLES

### EXAMPLE 1. PREPARATION OF AN ALKALI SOLUBLE POLYMER IN WATER (Colloids A and B)

Chain transfer agent, 1-dodecanethiol, 3 g, was accurately weighed and transferred to a three neck, round bottomed flask equipped with a stirrer, condensor and addition funnel. To this a solution of 106.7g 2-propanol, 94.0g styrene, 40.3g acrylic acid and 4.5g azobis(isobutyronitrile) initiator (AlBN) was added. After mixing to ensure uniformity, the flask was immersed in a water bath maintained at 82±2°C and the contents stirred at 120 rpm. Two hours after reaching reflux temp 23.4g of 2-propanol was slowly and uniformly added over a period of 30 minutes. Reflux was maintained for a further 2.5 hours. The flask contents were then cooled to 50°C and 24g of ammonium hydroxide was added. After complete mixing 400g of deionized (DI) water was added with 250 rpm agitation. The pH was then adjusted into the range 8.5-9.0 with additional ammonia. The contents of the flask were then heated with stirring to 70°C and the 2-propanol was removed by vacuum until the solids content reached 24-26 wt%, final pH 8.0-9.0. The molecular weight, Mw, was determined by GPC to be 5,070 daltons.

A second, lower molecular weight alkali soluble polymer (colloid B) was similarly prepared using 4.5g AlBN and 26.7g 2-propanol slowly added. The molecular weight, Mw, was determined by GPC to be 2,390 daltons.

### EXAMPLE 2. PREPARATION OF A COLLOID STABILIZED ACRYLIC EMULSION POLYMER (emulsions A and B)

Following the teaching of U.S. Pat. 5,455,299 emulsion polymers were prepared using the alkali soluble polymer solutions from Example 1 as stabilizing entities.

Colloid solution A, 230.8g, and 116.0g de-ionized water were weighed into a three neck, round bottomed flask equipped with a stirrer, condenser and two addition funnels. The flask was purged of oxygen by introducing nitrogen gas subsurface. Then the flask was heated in a water bath maintained at 80°C and the contents stirred at 70 rpm. When the contents temp reached 70°C a mixture of 4.2g styrene and 1.8g 2-ethylhexylacrylate was added and at 77°C an initiator solution of 0.03g ammonium persulfate (APS) in 5.19g DI water was added. After 15 minutes temp equilibration the stirrer agitation was increased to 180 rpm and a uniform slow addition of initiator solution consisting of 0.25g APS in 40.39g DI water was begun. The initiator was added over 230 minutes. At the same time uniform slow addition of a mixture of 80.13g styrene and 34.34g 2-ethylhexylacrylate was begun and completed over a period of 210 minutes. The reaction temperature was maintained at 80±2°C throughout polymerization. Following the monomer addition 2.88g DI water was added via the monomer addition funnel and the contents maintained at 80°C for a further 1.5 hours. The temperature was then cooled below 40°C and the pH adjusted to 9.1 with ammonia.

A second emulsion (B) was used following the same procedure with colloid B.

The properties of the emulsion polymers are given in the following Table:

| PROPERTIES | EMULSION A | EMULSION B |
|---|---|---|
| Solids, % | 33.9 | 33.2 |
| Viscosity, mPa.s | 7300 | 37 |
| Mean particle size, nm | 110 | 67 |

### EXAMPLE 3. PREPARATION OF A BINDER (Binders A and B)

Emulsion A, 1000g, prepared following the procedure of Example 2, was weighed into a two neck flask equipped with a stirrer and addition funnel. The contents were heated in a water bath to 40°C and the agitation set to 100 rpm. A higher boiling point plasticizer, 59.1g of dipropyleneglycol dibenzoate, was added slowly over 10 minutes. After a further 15 minutes of stirring 45.5g of a lower boiling point plasticizer / coalescing solvent, ethyleneglycol monobutylether, was added slowly over 30 minutes and agitation continued for a further 15 minutes. Upon cooling to 30°C the pH was adjusted to 9.0 with ammonia.

A second binder, Binder B, was prepared by the same procedure using Emulsion B.

The properties for the binders are given in the following Table:

| PROPERTIES | BINDER A | BINDER B |
|---|---|---|
| Solids, % | 34.2 | 34.0 |
| Viscosity, mPa.s | 1360 | 22 |
| Mean particle size, nm | 256 | 68 |

### EXAMPLE 4. PREPARATION OF CONDUCTIVE INKS (Inks A and B)

Binder A. 167.6g, was weighed into a plastic mixing vessel. A Ross high speed dispersing mixer was lowered into the liquid until the blade was positioned just above the bottom of the vessel and the mixing speed was set to 500 rpm. Silver flakes coated with oleic acid, 500g, were slowly incorporated into the binder. During this process the blade height was raised and lowered again to ensure complete wetting of the silver. The mixing speed was then increased to 1200 rpm and the conductive ink was allowed to mix for one hour. A cooling bath was used to maintain the temp below 30°C. Upon completion of the mixing the viscosity was measured and found to be 265 seconds using a no. 3 Zahn cup. This was considered to be too high for satisfactory flexographic printing. The sample was then diluted with 2.8% ammonia to a viscosity of 45 seconds and a total solids content of approximately 81%. On a dry basis the resulting ink, Ink A, contained 89.7% silver, thus the silver to binder ratio was 8.7:1.

A second conductive ink (Ink B) was prepared following the above procedure but using 168.6g of Binder B in order to achieve the same silver to binder ratio calculated on a dry basis. In this case the viscosity prior to ammonia dilution was 80 s. The sample was diluted with 2.8% ammonia to a viscosity of 33 s, total solids approximately 82%.

Calculated on a dry basis these inks had the following composition:

| COMPONENT | WEIGHT % |
|---|---|
| Alkali-soluble styrene acrylic resin | 1.19 |
| Insoluble styrene acrylate polymer | 6.74 |
| Ethylene glycol monobutyl ether | 1.34 |
| Benzoate plasticizer | 1.03 |
| Silver flake | 89.7 |

### EXAMPLE 5. PREPARATION OF A HIGHER SOLIDS CONDUCTIVE INK (INK C)

An ink was prepared from a binder (Binder C) of substantially similar composition to Binder B but having a solids content of 39 weight% and 235 mPa.s Brookfield viscosity. This binder was formulated into a conductive ink following the procedure of Example 4 but using 147g of Binder C in order to achieve the same silver to binder ratio calculated on a dry basis. Ammonia, 13.6 ml of 2.8%, was added to achieve a total solids content of 84.4 weight % and 32 s no. 3 Zahn cup viscosity. The higher solids content is desirable to promote more rapid drying.

### EXAMPLE 6. PERFORMANCE OF CONDUCTIVE INK C

The properties were as follows:

| | |
|---|---|
| DISPERSIBILITY of silver | Good |
| PRINTQUALITY (flexographic press) | Good |
| CONDUCTIVITY (ambient drying) | |
| 6 minutes | 50 mΩ/sq/mil |
| 1 hour - | 43 mΩ/sq/mil |
| 2 hours | 43 mrlsqlmil |

in which 1 mil is 25µm.

### CONDUCTIVITY (elevated temp.)

| | |
|---|---|
| 1 min. @ 70°C | 41 mΩ/sq/mil |
| 1 min. @ 120°C | 32 mΩ/sq/mil |
| 1 min. @ 150°C | 20 ml:2/sq/mil |

in which 1 mil is 25µm.

### FLEXIBILITY

| | |
|---|---|
| Initial conductivity | 32 mΩ/sq/mil |
| | (8 mΩ/sq) |
| Conductivity after 2 mm diameter mandrel bend | 32 mΩ/sq/mil |
| | (8 mΩ/sq) |
| Conductivity after 180° double crease under 2 kg load | 38 mΩ/sq/mil |
| | (9 mΩ/sq) |

in which 1 mil is 25µm.

### MOISTURE

| | |
|---|---|
| Initial conductivity | 16 mΩ/sq/mil |
| Conductivity after 24hours @85-C/85%RH - | 4 mΩ/sq/mil |

in which 1 mil is 25µm.

### REDISPERSIBILITY

The ink was able to be reconstituted after 17 months storage using a paint shaker for 5 minutes. The ink was well dispersed with good appearance and maintained its conductivity.

### EXAMPLE 7. (Comparative) PERFORMANCE OF A WATERBORNE CONDUCTIVE COMPOSITION HAVING NO ALKALI-SOLUBLE COMPONENT

An 85% dispersion in water of the components identified below was prepared in a high speed dispersing mixer as described above and exhibited the following performance:

| COMPONENT | WEIGHT (parts per 100) |
|---|---|
| Insoluble styrene acrylate-polymer | 7.93 |
| proprietary to Imperial Chemical Industries (ICI) | |
| Ethylene glycol monobutyl ether | 1.34 |
| Benzoate plasticizer | 1.03 |
| Silver flake | 89.7 |

| | |
|---|---|
| DISPERSIBILITY of silver | Poor |
| PRINT QUALITY (flexographic press) | Poor |
| CONDUCTIVITY (ambient drying for 2 hours) | 60 mΩ/sq/mil |

in which 1 mil is 25µm.

### REDISPERSIBILITY

After five 5 minutes of shaking in a paint shaker following 2 months storage, the quality of the composition was poor pastelike, gritty, and very viscous.

### EXAMPLE 8. (Comparative) PERFORMANCE OFA WATERBORNE CONDUCTIVE COMPOSITION HAVING 100% ALKALI-SOLUBLE RESIN

An 85% solution in water of the components identified below was prepared in a high speed dispersing mixer as described above and exhibited the following properties:

| COMPONENT | WEIGHT (parts per 100) |
|---|---|
| Alkali-soluble styrene resin | 7.93 |
| Ethylene glycol monobutyl ether | 1.34 |
| Benzoate plasticizer | 1.03 |
| Silver flake | 89.70 |
| DISPERSIBILITY of silver | Good |

### CONDUCTIVITY (ambient drying)

| | |
|---|---|
| 15 minutes | 37 mΩ/sq/mil |
| 1 hour | 24 mΩ/sq/mil |
| 2 hours | 23 mΩ/sq/mil |
| in which 1 mil is 25µm. | |

### CONDUCTIVITY (elevated temp.)

| | |
|---|---|
| 1 min. @ 150°C | 64mΩ/sq/mil;poor quality dry film |

in which 1 mil is 25µm.

### FLEXIBILITY

| | |
|---|---|
| Initial conductivity | 20 mΩ/sq/mil |
| Conductivity after mandrel bend | 20 mΩ/sq/mil |
| Conductivity after 180° double | 00 mΩ/sq/mil |
| crease under 2 kg load | (broken trace) |

in which 1 mil is 25µm.

### EXAMPLE 9 COMPOSITION WITH WATER INSOLUBLE VINYL EMULSION

An emulsion was prepared from 9.80 grams of a mixture of an alkali soluble styrene/acrylic acid copolymer and an styrene acrylate emulsion (insoluble), 10.00 grams of a poly(vinylchloride) emulsion (Viniblan 270 from Nisshin Kagaku Kogyo K.K., 0.20 grams of Arabic gum, and 56 grams of silver flake. The formulation was tested for performance and the results set out in the Tables in Example 10 as Formulation I.

### EXAMPLE 10. PERFORMANCE PROPERTIES OF INVENTIVE AND COMPARATIVE FORMULATIONS

Several conductive waterborne formulations were prepared to test for resistance development at ambient and elevated temperatures and under humidity conditions, and to compare the printability and flexibility of the inventive formulation relative to comparative formulations. All formulations were prepared by blending the components at room temperature as follows: the emulsions were loaded into a suitable vessel and stirred while any additives, water, and ammonia were added; silver flake was then added with stirring, and stirring continued for ten minutes. The final formulations were coated onto a Melinex O PET substrate using either a draw down application or a rotogravure printing application.

The draw down application was done with a 25µm wire bar coating a 50mm X 10mm rectangle (5 squares). The resistance was measured and recorded at ambient temperatures after 5, 15, 30, 60 and 120 minutes. The resistance of a second coating was measured and recorded after 5 minutes at ambient temperature, one minute at 70°C, one minute at 120°C, and one minute at 150°C. The resistance was calculated in Ohm/square/25pm using the formula (measured X thickness in pm) / (25µm X number of squares).

The rotogravure printing application was done with a Saueressig color proofer 90/200 with an engraved cylinder of 54 lines per cm and a rectangle of 220mm X 53mm (4.15 squares). Resistance was measured and calculated as for the draw down coatings, but using a track of 4.15 squares.

In order to test for flexibility of the dried conductive coating, a coating was printed via rotogravure printing onto 125µm thick PET substrate, after which the coating was dried for one minute at 150°C. A track measuring 100mm X 2mm was cut from the substrate and the resistance measured in Ohms, after which the tract was bent around a 2mm mandrel and the resistance measured again. In a further test of flexibility, the track was creased by folding with the coating to the inside (180°C bend) and the crease line rolled with a 2 kg weight. The track was then folded the other way (180°C bend) with the coating on the outside and the crease rolled again with a 2 kg weight. The resistance was measured and reported.

Resistance also was measured after being subjected to temperature and humidity conditioning for 24 hours at 85°C, and 85% relative humidity (RH). A draw down coating on a 50mm X 10mm track of PET was made and dried for one minute at 150°C. Resistance was measured one hour after removal from the temperature and humidity conditioning.

The formulations for the conductive waterborne compositions in parts by weight are set out in TABLE 1, FIGURE 3. Resistance values for those formulations are set out in TABLE 2, FIGURE 4, and as reported are normalized with respect to the thickness of the coating.

In addition to the Formulations set out in TABLE 1, FIGURE 3, two attempts were made to compose formulations containing 14.98 parts of the proprietary styrene acrylate emulsion from ICI, 2.38 parts of poly(acrylic acid), 1.34 parts of ethylene glycol monobutyl ether, 1.29 parts of dipropyleneglycol dibenzoate, and 1.50 parts of 10% ammonia water (Example 7). With the addition of the poly(acrylic acid), the compositions thickened and became unworkable.

Discussion of Results: Examples A and 1 are inventive examples and both contain an alkali soluble styrene/acrylic acid copolymer, and an insoluble styrene/acrylate copolymer. Example I further contains a vinyl emulsion and a plasticizer. Both samples showed very good development of conductivity at ambient and elevated temperatures and under temperature and humidity conditions, and very good printability. Flexibility was good for Example A and very good for Example 1.

Example B contained no alkali soluble component and showed poor printability (a decrease in conductivity on printing), and poor flexibility (a significant loss of conductivity upon creasing).

Example C contained no insoluble component and showed poor printability (a decrease in conductivity on printing), and no flexibility (was not able to be bent around the mandrel without breaking.)

Example D contained both an insoluble component and a soluble (acid) component; however, the acid was post-added to the insoluble component rather than being added to stabilize the insoluble emulsion. This ink was not printable.

Example E contained an ammonia neutralized acid containing polymer, and although it showed good conductivity and printability, it broke in the flexibility testing.

Example F was similar to Example E but contained plasticizer in an attempt to increase flexibility. This sample showed poor printability (a decrease in conductivity on printing), and broke in the flexibility testing.

Example G contained an insoluble polymer emulsion and a soluble acid containing polymer with an elastomer in place of plasticizer. This sample showed poor printability (a decrease in conductivity on printing).

Example H contained the same composition as Example G, except that a plasticizer was used in place of the elastomer. This sample showed poor printability (a decrease in conductivity on printing).

Examples A and I, containing the inventive conductive waterborne formulations, exhibited the best overall performance in development of conductivity, printability, and flexibility.

Formulations J and K were prepared with the addition of a poly(vinylchloride) emulsion to the styrene/acrylic acid copolymer (alkali soluble) and styrene acrylate emulsion (insoluble). Both samples cured to give good conductivity at ambient temperature and after thermal curing. Formulation K gave better conductivity on printing, after flexibility testing, and after temperature/humidity conditioning.

While the invention has been described above with reference to specific embodiments thereof, it is apparent that many changes, modifications and variations can be made without departing from the inventive concept disclosed herein. Accordingly, it is intended to embrace all such changes, modifications and variations that fall within the scope of the appended claims.

## Claims

1. A waterborne conductive composition comprising
(i) metal flakes or particles;
(ii) an alkali-soluble acrylic or methacrylic acid copolymer in an effective solvating amount of water and alkali to dissolve the (meth)acrylic acid copolymer;
(iii) a water-insoluble polymer dispersed in water; and
(iv) optionally, a coalescing agent, a plasticizer, or both,
the waterborne conductive composition being **characterized in that** said alkali-soluble (meth)acrylic acid copolymer is a copolymer of acrylic acid or methacrylic acid, with one or more hydrophobic ethylenically unsaturated comonomers.

2. The composition according to claim 1 in which the alkali-soluble (meth)acrylic acid copolymer is styrene-acrylic acid copolymer.

3. The composition according to claim 1 in which the water-insoluble polymer dispersed in water is selected from the group of polymers consisting of polyurethane, acrylic, polyester, and vinyl.

4. The composition according to claim 3 in which the water-insoluble polymer dispersed in water is poly(vinyl chloride).

5. The composition according to claim 1 in which the metal flakes or particles are selected from the group consisting of silver, copper, nickel, silver coated materials, copper coated materials, nickel coated materials, and mixtures thereof.

6. The composition according to claim 5 in which the metal flakes or particles are bimodal flakes coated with oleic acid.

7. The composition according to claim 1 in which the ratio of metal flakes or particles to the remaining solids content of the composition ranges from about 8 to about 10.

8. The composition according to claim 1 in which the coalescing agent is present and is selected from the group consisting of ethylene glycol monobutyl ether, 1,3 butylene glycol; propylene glycol, and ethylene glycol.

9. The composition according to claim 1 in which the plasticizer is present and is selected from the group consisting of dipropyleneglycol dibenzoate, dibutyl phthalate; dihexyl phthalate, dioctyl phthalate, di-iso-octyl phthalate, dinonyl phthalate, a mixture of C₇₋₉ dialkyl phthalates, ditridecyl phthalate, butyl benzyl phthalate, dibutyl adipate, dihexyl adipate, dioctyl adipate, di-iso-octyl adipate, dibutyl sebacate and dioctyl sebacate.

10. The composition according to claim 1 in which the water insoluble polymer is dispersed in water and is a copolymer comprising styrene and 2-ethylhexyl acrylate monomers.

11. A conductive coating disposed on a flexible substrate formed by printing and drying the composition according to claim 1.

12. An RFID antenna comprising the conductive coating according to claim 11.

## Patentansprüche

1. Wässrige leitfähige Zusammensetzung umfassend
(i) Metallflocken oder -partikel;
(ii) ein alkalilösliches Acryl- oder Methacrylsäure-Polymer in einer wirksamen solvatisierenden Menge von Wasser und Alkali, um das (Meth)acrylsäure-Polymer zu lösen;
(iii) ein in Wasser dispergiertes wasserunlösliches Polymer; und
(iv) gegebenenfalls ein Koaleszenzmittel, einen Weichmacher oder beide,
wobei die wasserhaltige leitfähige Zusammensetzung **dadurch gekennzeichnet ist, dass** das alkalilösliche (Meth)acrylsäure-Polymer ein Copolymer von Acrylsäure oder Methacrylsäure mit einem oder mehreren hydrophoben ethylenisch ungesättigten Comonomeren ist.

2. Zusammensetzung nach Anspruch 1, wobei das alkalilösliche (Meth)acrylsäure-Copolymer ein Styrol-Acrylsäure-Copolymer ist.

3. Zusammensetzung nach Anspruch 1, wobei das in Wasser dispergierte wasserunlösliche Polymer aus der Gruppe von Polymeren bestehend aus Polyurethan, Acryl, Polyester und Vinyl ausgewählt ist.

4. Zusammensetzung nach Anspruch 3, wobei das in Wasser dispergierte wasserunlösliche Polymer Poly(vinylchlorid) ist.

5. Zusammensetzung nach Anspruch 1, wobei die Metallflocken oder -partikel aus der Gruppe bestehend aus Silber, Kupfer, Nickel, silberbeschichteten Materialien, kupferbeschichteten Materialien, nickelbeschichteten Materialien und Mischungen davon ausgewählt sind.

6. Zusammensetzung nach Anspruch 5, wobei die Metallflocken oder -partikel bimodale Flocken sind, die mit Ölsäure beschichtet sind.

7. Zusammensetzung nach Anspruch 1, wobei das Verhältnis zwischen Metallflocken oder -partikeln und dem übrigen Feststoffgehalt der Zusammensetzung von ungefähr 8 bis ungefähr 10 reicht.

8. Zusammensetzung nach Anspruch 1, wobei das Koaleszenzmittel vorhanden ist und aus der Gruppe bestehend aus Ethylenglykolmonobutylether, 1,3-Butylenglykol; Propylenglykol und Ethylenglykol ausgewählt ist.

9. Zusammensetzung nach Anspruch 1, wobei der Weichmacher vorhanden ist und aus der Gruppe bestehend aus Dipropylenglykoldibenzoat, Dibutylphthalat, Dihexylphthalat, Dioctylphthalat, Diisooctylphthalat, Dinonylphthalat, einer Mischung aus C₇₋₉-Dialkylphthalaten, Ditridecylphthalat, Butylbenzylphthalat, Dibutyladipat, Dihexyladipat, Dioctyladipat, Diisooctyladipat, Dibutylsebacat und Dioctylsebacat ausgewählt ist.

10. Zusammensetzung nach Anspruch 1, wobei das wasserunlösliche Polymer in Wasser dispergiert ist und ein Copolymer ist, das Styrol und 2-Ethylhexylacrylat-Monomere umfasst.

11. Leitfähige Beschichtung, angeordnet auf einem flexiblen Substrat, das durch Drucken und Trocknen der Zusammensetzung nach Anspruch 1 gebildet ist.

12. RFID-Antenne umfassend die leitfähige Beschichtung nach Anspruch 11.

## Revendications

1. Composition conductrice à base d'eau comprenant
(i) des flocons ou des particules métalliques ;
(ii) un polymère d'acide acrylique ou méthacrylique soluble dans les matières alcalines en une quantité solvante efficace d'eau et de substance alcaline pour dissoudre le polymère d'acide (méth)acrylique,
(iii) un polymère insoluble dans l'eau dispersé dans l'eau ; et
(iv) éventuellement, un agent coalescent, un plastifiant, ou les deux, la composition conductrice à base d'eau étant **caractérisée en ce que** ledit polymère d'acide (méth)acrylique soluble dans les substances alcalines est un copolymère d'acide acrylique ou d'acide méthacrylique, avec un ou plusieurs comonomère(s) hydrophobe(s) éthyléniquement insaturé(s).

2. Composition selon la revendication 1, dans laquelle le copolymère d'acide (méth)acrylique soluble dans les substances alcalines est un copolymère de styrène-acide acrylique.

3. Composition selon la revendication 1, dans laquelle le polymère insoluble dans l'eau dispersé dans l'eau est choisi parmi le groupe des polymères constitués du polyuréthane, des polymères acryliques, du polyester et des polymères de vinyle.

4. Composition selon la revendication 3, dans laquelle le polymère insoluble dans l'eau dispersé dans l'eau est le poly(chlorure de vinyle).

5. Composition selon la revendication 1, dans laquelle les flocons ou les particules métalliques sont choisi(e)s parmi le groupe constitué de l'argent, du cuivre, du nickel, des matériaux revêtus d'argent, des matériaux revêtus de cuivre, des matériaux revêtus de nickel, et de leurs mélanges.

6. Composition selon la revendication 5, dans laquelle les flocons ou les particules métalliques sont des flocons bimodaux revêtus d'acide oléique.

7. Composition selon la revendication 1, dans laquelle le rapport des flocons ou des particules métalliques à la teneur en matières solides restantes de la composition s'étend d'environ 8 à environ 10.

8. Composition selon la revendication 1, dans laquelle l'agent coalescent est présent et est choisi parmi le groupe constitué de l'éther monobutylique d'éthylène glycol, du 1,3-butylène glycol ; du propylène glycol, et de l'éthylène glycol.

9. Composition selon la revendication 1, dans laquelle l'agent plastifiant est présent et est choisi parmi le groupe constitué du dibenzoate de dipropylèneglycol, du phtalate de dibutyle, du phtalate de dihexyle, du phtalate de dioctyle, du phtalate de di-iso-octyle, du phtalate de dinonyle, d'un mélange de phtalates de dialkyle en C₇₋₉, du phtalate de ditridécyle, du phtalate de butyl benzyle, de l'adipate de dibutyle, de l'adipate de dihexyle, de l'adipate de dioctyle, de l'adipate de di-iso-octyle, du sébacate de dibutyle et du sébacate de dioctyle.

10. Composition selon la revendication 1, dans laquelle le polymère insoluble dans l'eau est dispersé dans l'eau et est un copolymère comprenant du styrène et des monomères d'acrylate de 2-éthylhexyle.

11. Revêtement conducteur disposé sur un substrat souple formé par impression et séchage de la composition selon la revendication 1.

12. Antenne IRF comprenant le revêtement conducteur selon la revendication 11.
